# EUROPÄISCHE PATENTSCHRIFT

(11) **EP 3 034 658 B1**
(45) Veröffentlichungstag und Bekanntmachung des Hinweises auf die Patenterteilung: **14.06.2017**
(21) Anmeldenummer: 15198405.1
(22) Anmeldetag: 08.12.2015
(51) Int. Cl.: C30B 13/20, C30B 13/32, C30B 29/06, C30B 13/26

(54) **VERFAHREN ZUM ZÜCHTEN EINES EINKRISTALLS DURCH KRISTALLISIEREN DES EINKRISTALLS AUS EINER FLIESSZONE**
METHOD FOR GROWING A SINGLE CRYSTAL BY CRYSTALLISATION OF THE SINGLE CRYSTAL FROM A FLOATING ZONE
PROCEDE DESTINE A LA CROISSANCE D'UN MONOCRISTAL PAR CRISTALLISATION A PARTIR D'UNE ZONE DE FUSION

(30) Priorität: 18.12.2014 DE 102014226419
(43) Veröffentlichungstag der Anmeldung: 22.06.2016
(73) Patentinhaber: Siltronic AG, 81737 München (DE)
(72) Erfinder: Raming, Georg, 84367 Tann (DE); Altmannshofer, Ludwig, 83661 Lenggries (DE); Ratnieks, Gundars, 84489 Burghausen (DE); Möller, Martin, 84533 Haiming (DE); Mümmler, Frank, 84547 Emmerting (DE)
(74) Vertreter: Staudacher, Wolfgang

(56) Entgegenhaltungen:
- WO-A1-2008/125104
- DE-A1- 2 538 831
- JP-A- 2008 266 102

## Beschreibung

Gegenstand der Erfindung ist ein Verfahren zum Züchten eines Einkristalls durch Kristallisieren des Einkristalls aus einer Fließzone, wobei die Fließzone induktiv erhitzt wird und der kristallisierende Einkristall in eine Drehrichtung gedreht und die Drehrichtung entsprechend eines Wechselplans in Abständen umgekehrt wird.

Ein Verfahren der genannten Art ist das Zonenschmelzverfahren oder Float-Zone-Verfahren, kurz FZ-Verfahren. Es wird häufig zur Herstellung von Einkristallen aus Silizium eingesetzt, die wiederum zu Halbleiterscheiben weiterverarbeitet werden, aus denen elektronische Bauelemente hergestellt werden. In der klassischen Weise ausgeführt, wird ein polykristalliner Vorratsstab am unteren Ende geschmolzen und ein einkristalliner Keimkristall an die Schmelze gehalten und langsam abgesenkt, wobei im weiteren Verlauf des Verfahrens geschmolzenes Material am Keimkristall zu einem Einkristall kristallisiert. Keimkristall und Einkristall sitzen auf einer Welle, die mit einem Antrieb in Verbindung steht, der das Drehen, Heben und Senken der Welle ermöglicht. Das Volumen der Schmelze wird durch weiteres Schmelzen und Absenken des Vorratsstabs zu einer Fließzone vergrößert, die sich zwischen dem Vorratsstab und dem auf dem Keimkristall kristallisierenden Einkristall erstreckt. Die Fließzone stellt das für die Kristallisation des Einkristalls notwendige Material zur Verfügung. Durch das fortgesetzte Schmelzen des Vorratsstabs wächst der Einkristall, bis der Vorrat erschöpft ist.

Es ist nicht notwendig, einen Vorratsstab als Vorrat zu verwenden. Anstelle eines Vorratsstabs können auch Bruchstücke oder Granulat den Vorrat bilden. Der Vorrat muss auch nicht unbedingt polykristallin sein. In der US 2005/0188918 A1 und in der US 2009/0223949 A1 sind Verfahren beschrieben, in denen Granulat als Vorrat eingesetzt wird.

Es ist von Vorteil, den kristallisierenden Einkristall zu drehen und die Drehrichtung entsprechend eines Wechselplans in Abständen umzukehren. Diese als Wechseldrehung bezeichnete Maßnahme bewirkt eine gleichmäßigere Verteilung von Dotierstoffen im Einkristall und fördert, dass der Einkristall in der gewünschten zylindrischen Form wächst. In der US 2003/0024468 A1 ist eine Wechseldrehung beschrieben, die nach einem bestimmten Wechselplan durchgeführt wird.

Die Fließzone wird induktiv erhitzt und stabilisiert. Zu diesem Zweck ist eine Induktionsheizspule zwischen dem Vorrat und dem kristallisierenden Einkristall angeordnet. Die Induktionsheizspule ist üblicherweise eine nahezu ringförmige Flachspule mit einer Windung, und die Fließzone erstreckt sich durch ein zentrales Loch der Induktionsheizspule.

WO 2008/125104 A1 offenbart ein Verfahren zum Züchten eines Einkristalls durch Kristallisieren des Einkristalls aus einer Fließzone, wobei die Fließzone induktiv erhitzt wird, die Drehrichtung entsprechend eines Wechselplans in Abständen umgekehrt wird und eine Dauer des Drehrichtungswechsels von 0,1 bis 2 s als geeignet angesehen wird.

Der Bereich des Schlitzes der Induktionsheizspule, wo sich die Enden der Windung nahe kommen und die Stromzuführungen sind, ist kritisch, weil dort das von der Induktionsheizspule erzeugte elektromagnetische Feld deutlich stärker ist, als in den anderen Bereichen der Induktionsheizspule. Dieser Umstand kann den störungsfreien Verlauf der Kristallisation des Einkristalls gefährden. In der DE 2538831 wird vorgeschlagen, die Enden der Windung überlappen zu lassen, um die Feldstärke zu reduzieren. Gemäß der DE 10 2011 122 381 A1 kann ein Problem beim Kristallisieren eines konusförmigen Abschnitts des Einkristalls, das durch die Ungleichförmigkeit der Induktionsheizspule hervorgerufen wird, vermieden werden, indem der Wechselplan der Wechseldrehung vorsieht, dass der Drehbetrag in eine Drehrichtung nicht weniger als eine Drehung wird.

Aufgabe der vorliegenden Erfindung ist es, eine weitergehende Verbesserung vorzuschlagen, die gegen nachteilige Folgen einer überhöhten Feldstärke im Bereich des Schlitzes und der Stromzuführungen der Induktionsheizspule gerichtet ist.

Die Aufgabe wird gelöst durch ein Verfahren zum Züchten eines Einkristalls durch Kristallisieren des Einkristalls aus einer Fließzone, wobei die Fließzone induktiv erhitzt wird und der kristallisierende Einkristall in eine Drehrichtung gedreht wird und die Drehrichtung entsprechend eines Wechselplans in Abständen umgekehrt wird, und wobei die Drehbewegung des Einkristalls durch einen Antrieb ausgelöst wird, indem Kraft von einer Antriebswelle zu einer den Einkristall haltenden Welle übertragen wird, dadurch gekennzeichnet, dass
eine Verweildauer, während derer der Einkristall wegen der Drehrichtungsumkehr in einem Ruhezustand ist, auf nicht mehr als 60 ms begrenzt wird, und ein Riemen zur Kraftübertragung von der Antriebswelle zur den Einkristall haltenden Welle eingesetzt wird. Bevorzugt ist eine Begrenzung der Verweildauer auf nicht mehr als 40 ms, besonders bevorzugt deren Begrenzung auf nicht mehr als 30 ms.

Das Begrenzen der Verweildauer des Einkristalls im Ruhezustand verfolgt das Ziel, die Zeit zu minimieren, während derer ein Teil der Fließzone und des daran angrenzenden Einkristalls der überhöhten Feldstärke einseitig ausgesetzt ist. Eine vergleichsweise lange Verweildauer erhöht die Gefahr, dass der Einkristall an dessen oberen Rand unterhalb des Schlitzes und der Stromzuführungen zurückgeschmolzen wird.

Im Idealfall wäre die Verweildauer zu vernachlässigen. In der praktischen Anwendung gilt das nicht, weil Widerstände, beispielsweise Reibungskräfte im Lager der Welle und im Zusammenhang mit der Kraftübertragung vom Antrieb auf die Welle, erst überwunden werden müssen, ehe sich die Welle und damit der Einkristall nach einem dem Antrieb übermittelten Signal zur Beschleunigung tatsächlich in Bewegung setzt.

Bevorzugte Maßnahme zur Begrenzung der Verweildauer des Einkristalls im Ruhezustand ist das Steuern der Drehgeschwindigkeit eines die Drehbewegung des Einkristalls auslösenden Antriebs während einer Beschleunigungsphase entsprechend der Vorgabe eines Geschwindigkeitsverlaufs, der zufolge die Zunahme der Drehgeschwindigkeit des Antriebs am Beginn der Beschleunigungsphase und zumindest während einer Zeitspanne von nicht weniger als 1/4 der Beschleunigungsphase von nicht weniger als 3000 Umdrehungen/min pro Minute beträgt. Die Zunahme der Drehgeschwindigkeit des Antriebs ist während dieser Zeitspanne vorzugsweise linear und bewirkt, dass die Drehbewegung des Einkristalls auch tatsächlich schneller wiedereinsetzt. Bevorzugt beträgt die Zunahme der Drehgeschwindigkeit des Antriebs während dieser Zeitspanne nicht weniger als 3500, besonders bevorzugt nicht weniger als 3800 U/min². Eine Zunahme der Drehgeschwindigkeit des Antriebs von über 4500 U/min² birgt allerdings die Gefahr, dass wegen ihrer Wirkung Material der Fließzone vom kristallisierenden Einkristall gedrängt wird.

Der Beschleunigungsphase geht eine Bremsphase voraus, während der der Antrieb entsprechend der Vorgabe eines Geschwindigkeitsverlaufs gesteuert wird, durch den die Drehgeschwindigkeit des Antriebs bis zum Erreichen des Ruhezustands des Einkristalls abgesenkt wird. Die Abnahme der Drehgeschwindigkeit des Antriebs gemäß der Vorgabe ist vorzugsweise ebenfalls linear.

Der Betrag der Zunahme der Drehgeschwindigkeit des Antriebs gemäß der Vorgabe des Geschwindigkeitsverlaufs ist am Beginn der Beschleunigungsphase während der Zeitspanne von mindestens 1/4 der Beschleunigungsphase vorzugsweise größer als der Betrag der Abnahme der Drehgeschwindigkeit des Antriebs gemäß Vorgabe des Geschwindigkeitsverlaufswährend einer entsprechenden Zeitspanne vor dem Ende der vorausgehenden Bremsphase.

Die Zunahme der Geschwindigkeit des Antriebs auf nicht weniger als 3000 U/min² gemäß der Vorgabe des Geschwindigkeitsverlaufs des Antriebs am Beginn der Beschleunigungsphase bewirkt auch, dass ein Überschwingen der Drehbewegung des Einkristalls eher vermieden wird. Beim Überschwingen ist die Drehgeschwindigkeit des Einkristalls zeitweise größer als die von der Vorgabe des Geschwindigkeitsverlaufs des Antriebs vorgesehene Drehgeschwindigkeit des Antriebs und pendelt im weiteren zeitlichen Verlauf um den Wert der Vorgabe. Das Überschwingen ist ein Zeichen dafür, dass Widerstände, die der Drehbewegung des Einkristalls entgegenwirken, abrupt überwunden worden sind.

Es ist deshalb zweckmäßig, dass beim Auslösen der Drehbewegung des Antriebs eine möglichst verlustfreie Kraftübertragung vom Antrieb auf die den Einkristall haltende Welle erfolgt und die übertragene Kraft möglichst nur dem In-Gang-Setzen und Unterhalten der Drehbewegung des Einkristalls zugute kommt. Es wird ein Riemen zur Kraftübertragung von der Antriebswelle zur den Einkristall haltenden Welle eingesetzt. Vorzugsweise ist ein Antrieb mit vibrationsarmer Kraftübertragung mittels eines Riemens vorgesehen, und es wird eine vergleichsweise hohe Riemenspannung zwischen einer Antriebswelle und der den Einkristall haltenden Welle gewählt. Vorzugsweise liegt die Riemenspannung nahe an der zulässigen mechanischen Belastungsgrenze des eingesetzten Riemens. Besonders bevorzugt ist eine Riemenspannung, die den bei stehendem Antrieb unter Spannung stehenden Teil des Riemens nach mechanischer Anregung, beispielsweise durch einen kurzen Schlag, zu einer Eigenschwingung von nicht weniger als 100 und nicht mehr als 150 Hz veranlasst.

Die Überhöhung der Feldstärke im Bereich des Schlitzes und der Stromzuführungen wird vorzugsweise begrenzt. So sollte die elektrische Leistung, die in diesem Bereich abgegeben wird, nicht größer sein als das Fünffache der elektrischen Leistung, die von der Induktionsheizspule in Bereichen abgegeben wird, die vom Schlitz und den Stromzuführungen weiter entfernt sind. Die Induktionsheizspule ist deswegen vorzugsweise als Flachspule mit einer einzigen Windung ausgebildet, deren Enden sich überlappen. Sich in einem spitzen Winkel verjüngende Enden, die sich überlappen, sind besonders bevorzugt.

Das erfindungsgemäße Verfahren ist besonders vorteilhaft, wenn eine Induktionsheizspule mit vergleichsweise geringer Höhe verwendet wird oder wegen Platzmangels verwendet werden muss. Die Höhe der Induktionsheizspule ist der größte Abstand zwischen der Oberseite und der Unterseite der Induktionsheizspule. Eine geringe Höhe der Induktionsheizspule verstärkt die Überhöhung der Feldstärke im Bereich des Schlitzes und der Stromzuführungen der Induktionsheizspule. Platzmangel besteht insbesondere, wenn über der Induktionsheizspule eine Platte oder ein Tiegel bereitgestellt wird, um dort Granulat und/oder Bruchstücke zu schmelzen.

Das erfindungsgemäße Verfahren wird vorzugsweise zur Herstellung von Einkristallen aus Halbleitermaterial eingesetzt, besonders bevorzugt zur Herstellung von Einkristallen aus Silizium. Der Vorrat zum Erzeugen der Fließzone ist vorzugsweise polykristallin und liegt in Form eines Stabes, von Bruchstücken und/oder Granulat vor.

Die Erfindung wird nachfolgend an Hand von Zeichnungen näher erläutert.
Fig.1 und Fig.2 zeigen jeweils ein Diagramm mit gestrichelten Kurven, die die Vorgabe des Verlaufs der Drehgeschwindigkeit des Antriebs zwischen dem Beginn der Bremsphase und dem Ende der Beschleunigungsphase repräsentieren. Die durchgezogene Linie repräsentiert den Verlauf der resultierenden Drehgeschwindigkeit des vom Antrieb in Bewegung gesetzten Einkristalls.
Fig.3 zeigt die schematische Darstellung der Kraftübertragung von einer Antriebswelle zu einer einen Einkristall haltenden Welle über einen Riemen.

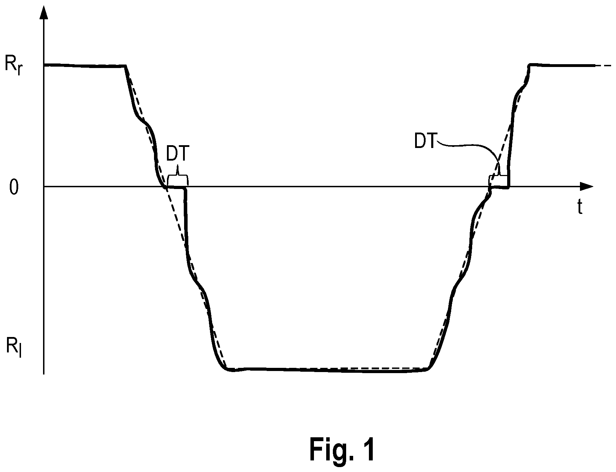

Gemäß Fig.1 ist der Verlauf der Drehgeschwindigkeit des Antriebs gemäß Vorgabe derart gewählt, dass die Beträge der Abnahme der Drehgeschwindigkeit am Ende der Bremsphase und der Zunahme der Drehgeschwindigkeit zu Beginn der Beschleunigungsphase gleich sind. Rᵣ und Rₗ bezeichnen die Drehrichtungen der Drehbewegungen und deren Drehgeschwindigkeiten in Umdrehungen pro Minute. Die Zunahme der Drehgeschwindigkeit des Antriebs zu Beginn der Beschleunigungsphase liegt unter 3000 U/min². Es resultiert eine vergleichsweise lange Verweildauer DT des Einkristalls im Ruhezustand und der Verlauf der Drehgeschwindigkeit des Einkristalls zeigt ein Überschwingen während der Beschleunigungsphase an.

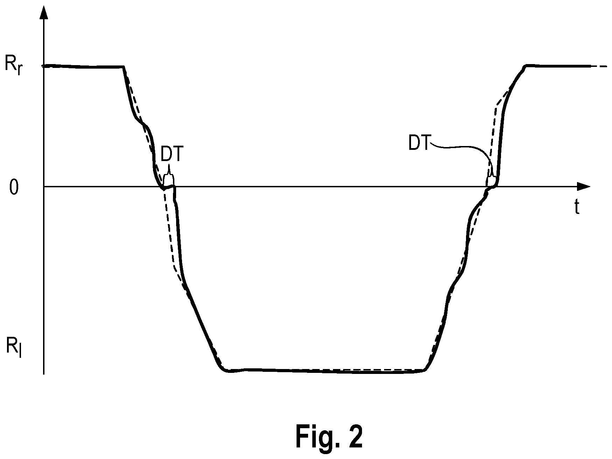

Gemäß Fig.2 ist der Verlauf der Drehgeschwindigkeit des Antriebs derart gewählt, dass die Beträge der Abnahme der Drehgeschwindigkeit am Ende der Bremsphase und der Zunahme der Drehgeschwindigkeit zu Beginn der Beschleunigungsphase nicht gleich sind. Rᵣ und Rₗ bezeichnen wieder die Drehrichtungen der Drehbewegungen und deren Drehgeschwindigkeiten in Umdrehungen pro Minute. Der Betrag der Abnahme der Drehgeschwindigkeit am Ende der Bremsphase ist kleiner als der Betrag der Beschleunigung der Drehgeschwindigkeit zu Beginn der Beschleunigungsphase. Insbesondere beträgt die Zunahme der Drehgeschwindigkeit des Antriebs zu Beginn der Beschleunigungsphase 3500 U/min². Es resultiert eine kürzere Verweildauer DT des Einkristalls im Ruhezustand von weniger als 60 ms und der Verlauf der Drehgeschwindigkeit des Einkristalls zeigt kein Überschwingen während der Beschleunigungsphase an.

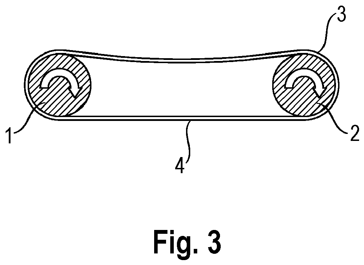

Der gemäß Fig.2 erzielte Verlauf der Drehgeschwindigkeit des Einkristalls wurde durch Kraftübertragung von einer Antriebswelle 1 auf eine den Einkristall haltenden Welle 2 mittels eines Riemens 3 erzielt (Fig.3). Im gespannten unteren Teil 4 des Riemens 3 wurde bei Stillstand der Antriebswelle eine Eigenschwingung von 140 Hz gemessen.

## Patentansprüche

1. Verfahren zum Züchten eines Einkristalls durch Kristallisieren des Einkristalls aus einer Fließzone, wobei die Fließzone induktiv erhitzt wird und der kristallisierende Einkristall in eine Drehrichtung gedreht wird und die Drehrichtung entsprechend eines Wechselplans in Abständen umgekehrt wird, und wobei die Drehbewegung des Einkristalls durch einen Antrieb ausgelöst wird, indem Kraft von einer Antriebswelle zu einer den Einkristall haltenden Welle übertragen wird, **dadurch gekennzeichnet, dass**
eine Verweildauer, während derer der Einkristall wegen der Drehrichtungsumkehr in einem Ruhezustand ist, auf nicht mehr als 60 ms begrenzt wird, und ein Riemen zur Kraftübertragung von der Antriebswelle zur den Einkristall haltenden Welle eingesetzt wird.

2. Verfahren nach Anspruch 1, **gekennzeichnet durch** Steuern der Drehgeschwindigkeit des Antriebs während einer Beschleunigungsphase entsprechend einer Vorgabe eines Geschwindigkeitsverlaufs, der zufolge die Zunahme der Drehgeschwindigkeit des Antriebs am Beginn der Beschleunigungsphase während einer Zeitspanne von nicht weniger als 1/4 der Beschleunigungsphase nicht weniger als 3000 U/min² beträgt.

3. Verfahren nach Anspruch 2, **dadurch gekennzeichnet, dass** der Betrag der Zunahme der Drehgeschwindigkeit des Antriebs gemäß der Vorgabe des Geschwindigkeitsverlaufs am Beginn der Beschleunigungsphase während der Zeitspanne von mindestens 1/4 der Beschleunigungsphase größer ist als der Betrag der Abnahme der Drehgeschwindigkeit des Antriebs gemäß Vorgabe des Geschwindigkeitsverlaufs während einer entsprechenden Zeitspanne vor dem Ende einer Bremsphase, die der Beschleunigungsphase vorausgeht.

4. Verfahren nach einem der Ansprüche 1 bis 3, **gekennzeichnet durch** das Erhitzen der Fließzone mit einer Induktionsheizspule, die als Flachspule mit einer Windung ausgebildet ist, deren Enden sich überlappen.

5. Verfahren nach Anspruch 3, **gekennzeichnet durch** das Erhitzen der Fließzone mit einer Induktionsheizspule, die als Flachspule mit einer Windung ausgebildet ist und eine Höhe hat, die nicht mehr als 20 mm beträgt.

## Claims

1. Method for growing a single crystal by crystallizing the single crystal from a flow zone, the flow zone being inductively heated and the crystallizing single crystal being rotated in a direction of rotation and the direction of rotation being reversed at intervals in accordance with an alternating plan, and the rotational movement of the single crystal being initiated by a drive, in that force is transmitted from a drive shaft to a shaft holding the single crystal, **characterized in that** a dwell time during which the single crystal is in a state of rest because of the reversal of the direction of rotation is limited to no more than 60 ms, and a belt is used for the force transmission from the drive shaft to the shaft holding the single crystal.

2. Method according to Claim 1, **characterized by** controlling the rotational speed of the drive during an acceleration phase in accordance with a presetting of a speed profile, as a result of which the increase in the rotational speed of the drive at the beginning of the acceleration phase, during a time period of no less than 1/4 of the acceleration phase, is no less than 3000 rpm².

3. Method according to Claim 2, **characterized in that** the amount of the increase in the rotational speed of the drive according to the presetting of the speed profile at the beginning of the acceleration phase, during the time period of at least 1/4 of the acceleration phase, is greater than the amount of the decrease in the rotational speed of the drive according to the presetting of the speed profile during a corresponding time period before the end of a deceleration phase that precedes the acceleration phase.

4. Method according to one of Claims 1 to 3, **characterized by** the heating of the flow zone with an induction heating coil, which is formed as a flat coil with one turn, the ends of which overlap.

5. Method according to Claim 3, **characterized by** the heating of the flow zone with an induction heating coil, which is formed as a flat coil with one turn and has a height that is no more than 20 mm.

## Revendications

1. Procédé de croissance d'un monocristal par cristallisation du monocristal à partir d'une zone d'écoulement, la zone d'écoulement étant chauffée par induction et le monocristal cristallisant étant tourné dans un sens de rotation, et le sens de rotation étant inversé périodiquement conformément à un plan de changement, et le mouvement de rotation du monocristal étant déclenché par un entraînement par le fait que la force d'un arbre d'entraînement est transmise à un arbre retenant le monocristal, **caractérisé en ce qu'**une durée de séjour pendant laquelle le monocristal est dans un état de repos à cause de l'inversion du sens de rotation est limitée à 60 ms maximum, et une courroie est mise en oeuvre pour la transmission de force à partir de l'arbre d'entraînement vers l'arbre retenant le monocristal.

2. Procédé selon la revendication 1, **caractérisé par** la commande de la vitesse de rotation de l'entraînement pendant une phase d'accélération conformément à une spécification d'une courbe de vitesse en fonction de laquelle l'augmentation de la vitesse de rotation de l'entraînement au début de la phase d'accélération est au moins égale à 3 000 tr/min² pendant un laps de temps au moins égal à 1/4 de la phase d'accélération.

3. Procédé selon la revendication 2, **caractérisé en ce que** la valeur de l'augmentation de la vitesse de rotation de l'entraînement conformément à la spécification de la courbe de vitesse au début de la phase d'accélération pendant le laps de temps d'au moins 1/4 de la phase d'accélération est supérieure à la valeur de la diminution de la vitesse de rotation de l'entraînement conformément à la spécification de la courbe de vitesse pendant un laps de temps correspondant avant la fin d'une phase de freinage qui précède la phase d'accélération.

4. Procédé selon l'une des revendications 1 à 3, **caractérisé par** le réchauffement de la zone d'écoulement avec une bobine de chauffage par induction qui est constituée en tant que bobine plate avec un enroulement dont les extrémités se chevauchent.

5. Procédé selon la revendication 3, **caractérisé par** le réchauffement de la zone d'écoulement avec une bobine de chauffage par induction qui est constituée en tant que bobine plate avec un enroulement et qui a une hauteur qui ne dépasse pas 20 mm.
